# EUROPEAN PATENT APPLICATION

(11) **EP 4 730 399 A1**
(43) Date of publication of application: **22.04.2026**
(21) Application number: 24823736.4
(22) Date of filing: 13.06.2024
(51) Int. Cl.: H01L 29/778, H01L 29/66, H01L 29/40, H01L 29/20

(54) **HIGH ELECTRON MOBILITY TRANSISTOR AND MANUFACTURING METHOD THEREOF**

(30) Priority: 13.06.2023 US 202363507778 P
(71) Applicant: Lucid Microsystems Pte Ltd., Suwon-si Gyeonggi-do 16512 (KR)
(72) Inventor: GAO, Zihao Mike, Gilbert, Arizona 85295 (US); REN, Xiaowei, Plano, Texas 75093 (US); LEE, Ki Sun, Pleasanton, California 94566 (US); SONG, Kyung Hoon, San Jose, California 95124 (US); LEE, Young Min, Seoul 05698 (KR); EOM, Han Yong, Sunnyvale, California 94087 (US)
(74) Representative: patcare Patentanwälte Partnerschaft mbB
(86) International application number: PCT/KR2024/008152
(87) International publication number: WO 2024/258219

(57) **Abstract**

An embodiment provides a high electron mobility transistor (HEMT) comprising: a first drain terminal; a gate terminal; a second drain terminal; a channel layer, of which a portion forms a first element together with the first drain terminal and the gate terminal and the other portion forms a second element together with the second drain terminal and the gate terminal; and a barrier layer including a first barrier layer that forms, in the first element, a first two-dimensional electron gas (2 DEG) region at the interface with the channel layer, and a second barrier layer that forms, in the second element, a second two-dimensional electron gas region at the interface with the channel layer, wherein the physical properties of the first barrier layer and the second barrier layer are different from each other.

## Description

### Technical Field

The present disclosure relates to a high electron mobility transistor and its manufacturing technology.

### Background Art

All silicon power metal-oxide-semiconductor field-effect transistors (MOSFETs) have intrinsic body diodes parallelly connected to devices' drain and source. As known, diodes are one-way conductional devices in the forward-bias state. Accordingly, when a MOSFET is operated in the third quadrant of current-voltage (IV) schemes, its body diode is in a forward-bias condition, thus showing either classical diode IV characteristics at zero or negative gate biases, or resistive behaviors, depending on values of positive gate biases applied. Hence, as conductivity control devices, MOSFETs are normally used in the first quadrant for majority applications, that is, switching, amplifying, etc. In other words, silicon MOSFETs are one-directional devices operated in the first quadrant.

Over the past few decades, the power industry has started to use gallium nitride (GaN) material for transistor fabrications due to its high energy band gap and high electron mobility, which attribute to transistor's high performances. GaN-based transistor is called high electron mobility transistor (HEMT), rendering transistor's low on-resistance. This type of compound transistor has become one of main emerging devices in power electronics with many benefits from high switching frequency, high power density, high thermal conductivity, etc., to highly efficient system designs and small footprints.

Unlike silicon transistors, GaN HEMT does not have a body diode and its current conduction is through 2-dimensional electron gas (2DEG) layer with thickness of a few nanometers. 2DEG is presented at the interface between barrier layer of AlxGal-xN and channel layer of GaN due to spontaneous and piezoelectric polarization of two layers.

There are many ways to adjust 2DEG surface charge density, i.e., changing aluminum mole fraction in barrier layer, n-type doping in both layers, etc. When homogenous epitaxial layers are used with identical layout dimensions across both drain and source regions, GaN HEMT would have identical IV curves in the first and third quadrants but in the opposite direction. That is, these curves are symmetric about the origin in their IV schemes. In this sense, GaN HEMT is a bi-directional device in contrast to one-directional silicon MOSFET.

When such a device is used for bi-directional conductions, it is unnecessary to differentiate GaN HEMT's source and drain. Naming of the transistor may be simplified as bi-directional GaN (bi-GaN). For bi-GaN, drain1 (D1), drain2 (D2), and gate are labeled to stand for three terminals of the transistor and D1/D2 terminals are interchangeable when homogenous epitaxial layers and identical layout dimensions across D 1 and D2 regions are used.

Based on the bi-directional property of GaN HEMT, a few applications are becoming popular, such as OVP (over voltage protection) circuits for smart phone charging, high side load switching etc. The construction of bi-GaN HEMT devices is symmetrical on D 1 and D2 with the equal high voltage capability. As a result, Ron of the bi-GaN HEMTs is increased compared to single directional device counterpart which present the challenge for using the dual functions where one of the functions requires lower Ron, hence, limited the performance.

GaN HEMT is also known for higher material and process cost compared to silicon and other compound semiconductor processes. Although the performance has been very attractive, the high cost has been a big factor for the market hesitation in making this technology a more commercial choice. Reducing the die size and improving the packing density are always a fundamental goal not only for the performance but also, more importantly, the must for this industry.

### DETAILED DESCRIPTION OF THE INVENTION

### Technical Problem

From this background, an aspect of the present disclosure is directed to providing the solution for improving on-resistance Ron performance, and providing a technique to enable expansion of bi-GaN application programs and die size reduction for better packing density and lower die cost.

Bi-GaN opens a door for novel applications that a silicon transistor would never be experienced, such as bidirectional switching. In this connection, one Bi-GaN may replace two back-to-back connected Si NMOSFET in a common source configuration to achieve the bi-directional switching which simplifies the design as well as reduce the chip size.

With innovative gate driver designs, bi-GaN may perform two different functionalities simultaneously. The common practice for Bi-GaN is to construct D1 and D2 symmetrically around the gate with the equal distance of drain extension to gate and with the same two-dimensional electron gas (2DEG) density. However, the different performance of Bi-GaN may be desired for D1 and D2, depending on detailed application requirements. For example, one functionality might be the high voltage switching in the first quadrant, while the other might be the reverse voltage blocking in the third quadrant. The symmetrically designed Bi-GaN may well satisfy one function but penalize the other so the overall performance may be limited.

Functionality wise, bi-GaN may run into situations where roles of D1 and D2 are competing thus limiting each other. For example, the high voltage switching side may look for the high breakdown and switching capability, while the reverse blocking side may focus on voltage blocking capability. The high voltage switching side with high breakdown brings in a higher Ron. The Ron on the reverse voltage blocking side is in series to the Ron of the high voltage switching side. This additional Ron adding on to the Ron of high switching and high breakdown side where Ron needs to be minimized affect the switching performance negatively. Accordingly, balancing individual performance of bi-GaN in different mode becomes challenging because of different devices' performance goals.

The solution is to customize the 2DEG for D 1 and D2 using the fundamental GaN device principle and processing essentials to maximize the performance of each side and further reduce the device pitch to improve the packing density simultaneously.

### Technical Solution

An embodiment provides a high electron mobility transistor (HEMT), including: a first drain terminal; a gate terminal; a second drain terminal; a channel layer, a portion of which forms a first device together with the first drain terminal and the gate terminal, and another portion of which forms a second device together with the second drain terminal and the gate terminal; and a first barrier layer forming a first 2DEG region at an interface with the channel layer within the first device, and a second barrier layer forming a second 2DEG region at the interface with the channel layer within the second device, the first barrier layer and the second barrier layer including a barrier layer with different material properties.

The first device may operate as a voltage blocking device, and the second device may operate as a switching device.

The first barrier layer and the second barrier layer include an AlGaN material, and Al mole fractions in the first barrier layer and the second barrier layer may be different from each other.

Due to differences in material properties between the first barrier layer and the second barrier layer, electron densities of the first 2DEG region and the second 2DEG region may be different from each other.

An electron density of the second 2DEG region may be higher than an electron density of the first 2DEG region.

A length between the first drain terminal and the gate terminal on an upper surface of the channel layer may be different from a length between the second drain terminal and the gate terminal.

Doping concentrations in the first barrier layer and the second barrier layer may be different from each other.

The HEMT is a horizontal type, wherein: the channel layer may be disposed below the first drain terminal, the gate terminal, and the second drain terminal in a vertical direction; the first drain terminal, the gate terminal, and the second drain terminal may be disposed in that order in a horizontal direction; and a ground plate may be disposed between the gate terminal and the second drain terminal in the horizontal direction.

The ground plate may be disposed between the gate terminal and the second drain terminal and may not be disposed between the gate terminal and the first drain terminal.

Another embodiment provides a high electron mobility transistor (HEMT), including: a first drain terminal; a gate terminal; second drain terminal; a channel layer, a portion of which forms a first device together with the first drain terminal and the gate terminal, and another portion of which forms a second device together with the second drain terminal and the gate terminal; and a barrier layer that forms a two-dimensional electron gas (2DEG) region at an interface with the channel layer and forms the 2DEG regions of different densities in the first device and the second device.

A material property of the barrier layer in the first device and a material property of the barrier layer in the second device may be different from each other.

The barrier layer includes an AlGaN material, and an Al mole fraction of the AlGaN material in the first device and the second device may be different from each other.

An N-type doping concentration of the barrier layer in the first device and the second device may be different from each other.

A 2DEG density of the second device may be 1.5 times or more than a 2DEG density of the first device.

The first device may operate as a voltage blocking device, and the second device may operate as a switching device.

Yet another embodiment provides a method of manufacturing a high electron mobility transistor (HEMT), wherein the method includes: forming a channel layer in the HEMT, a portion of which forms a first device together with a first drain terminal and a gate terminal, and another portion of which forms a second device together with a second drain terminal and the gate terminal; forming a first barrier layer having a first material property on the channel layer; forming the gate terminal on the first barrier layer; forming a first protective layer on the first barrier layer and the gate terminal; removing the first protective layer and the first barrier layer from the second device through etching; and forming a barrier layer including the first barrier layer and a second barrier layer with different material properties by laminating the second barrier layer having a second material property on the etched portion of the first barrier layer.

The method of manufacturing the HEMT may further include: laminating the second barrier layer having the second material property on the etched portion of the first barrier layer and then forming a second protective layer on the second barrier layer; forming an oxide film on the second protective layer; polishing the oxide film using the second protective layer as an endpoint; removing a first oxide film remaining in the first device among the oxide films; removing the second barrier layer and the second protective layer from regions of the oxide films excluding the portion protected by a second oxide film remaining in the second device; and removing the remaining second oxide film and the first protective layer.

The first barrier layer and the second barrier layer may be formed by metal-organic chemical vapor deposition (MOCVD).

The oxide film may be formed by plasma-enhanced chemical vapor deposition (PECVD).

The polishing may be chemical mechanical planarization (CMP).

### Effects of the Invention

As described above, an embodiment of the present disclosure can provide the solution for improving on-resistance Ron performance, and provide a technique to enable expansion of bi-GaN application programs and die size reduction for better packing density and lower die cost.

### BRIEF DESCRIPTION OF THE DRAWINGS

FIG. 1 is a cross-sectional view of an HEMT according to an embodiment.
FIG. 2 is an enlarged view of terminals and a channel layer in a cross section of a GaN HEMT according to an embodiment.
FIG. 3 is a diagram illustrating the configuration of a switching device according to an embodiment.
FIG. 4 is a diagram illustrating the configuration of a voltage blocking device according to an embodiment.
FIGS. 5 to 13 are diagrams illustrating a method of forming barrier layers with different material properties among the manufacturing methods of HEMT according to an embodiment.
FIG. 14 is a graph showing the relationship between 2DEG density and on-resistance.
FIG. 15 is a graph showing the relationship between 2DEG density and breakdown voltage.

### Mode for Implementing the Invention

Hereinafter, some embodiments of the present disclosure will be described in detail with reference to exemplary drawings. It is to be noted that in assigning reference numerals to respective elements in the drawings, the same reference numerals designate the same elements although the elements are shown in different drawings. Furthermore, in describing the present disclosure, a detailed description of the related known functions and constructions will be omitted if it is deemed to make the gist of the present disclosure vague.

Furthermore, in describing the elements of the present disclosure, terms, such as the first, second, A, B, a, and b, may be used. However, the terms are used to only distinguish one element from the other element, but the essence, order, and sequence of the elements are not limited by the terms. Furthermore, in the case in which one element is described to be "connected", "coupled," or "jointed" to the other element, the one element may be directly connected or coupled to the other element, but it should be understood that a third element may be "connected", "coupled," or "jointed" between the two elements.

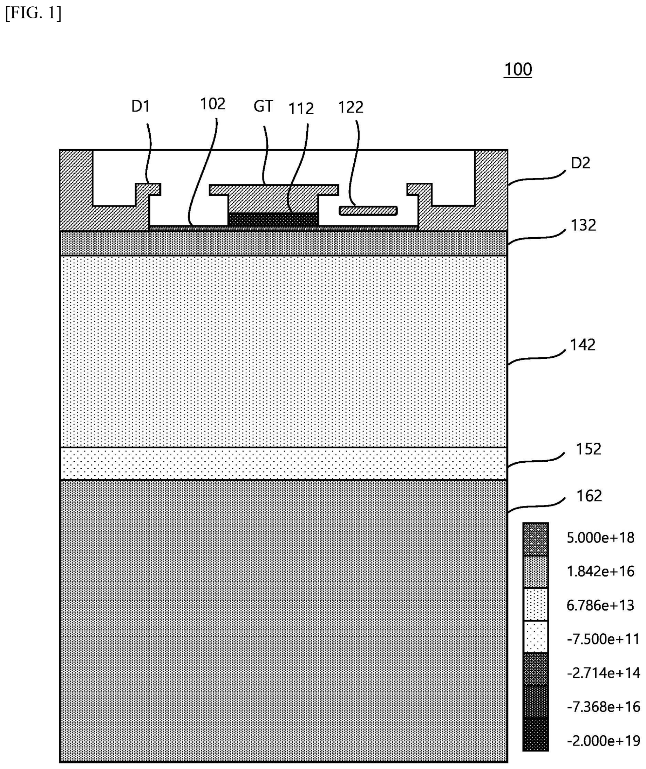

FIG. 1 is a cross-sectional view of an HEMT according to an embodiment.

Referring to FIG. 1, a high electron mobility transistor (HEMT) may include a first drain terminal (D1), a gate terminal (GT), and a second drain terminal (D2). For convenience of explanation, the side where the terminals D1, GT, and D2 are located is referred to as an upper side, and the side where a substrate layer 162 is formed is referred to as a lower side.

An HEMT 100 is a semiconductor device with high electron mobility and is known to exhibit excellent performance in high-speed switching and high frequency regions. The HEMT 100 is based on two-dimensional electron gas (2DEG). At the interface between a barrier layer 102 and a channel layer 132 included in the HEMT 100, spontaneous polarization and strained polarization combine to form a strong electric field. This phenomenon may induce abundant electrons into the channel layer 132 to form the 2DEG.

The electrons of 2DEG have a very low effective mass and may have high mobility due to little scattering due to lattice defects or impurities. Due to these properties of 2DEG, the HEMT 100 may operate at a higher frequency, and switching speed is also improved.

The HEMT 100 is known to have low noise and high energy efficiency based on the aforementioned properties. Additionally, the HEMT 100 has a relatively low on-resistance, which may increase the efficiency of power application apparatuses. Additionally, the HEMT 100 may withstand high power density due to the 2DEG formed by a strong electric field.

The HEMT 100 may be made based on gallium nitride (GaN).

GaN HEMT is a high-performance electronic device and may have attributes especially suitable for high-power, high-frequency applications. The GaN HEMT is known to have superior electrical properties than traditional silicon-based transistors, which is due to the physical and electrical attributes of a GaN material. Hereinafter, an embodiment will be described mainly based on the example where the HEMT is a GaN HEMT 100.

The barrier layer 102 may be made of AlGaN. In addition, the channel layer 132 may be made of GaN.

The GaN HEMT 100 may include the 2DEG. The GaN HEMT 100 may form the 2DEG at the interface of the barrier layer 102 and the channel layer 132 in an AlGaN/GaN structure. The 2DEG create channels through which electrons may move with very high mobility.

The GaN has a very high breakdown voltage (BV). In addition, the GaN has high thermal conductivity. Accordingly, the GaN HEMT 100 may operate stably even at high voltages and effectively dissipates heat, making it suitable for high-power applications.

The GaN HEMT 100 may have a high electron channel density due to the large number of electrons provided through the barrier layer 102, thereby achieving low on-resistance Ron and high current capacity. Additionally, the GaN HEMT 100 may have a very fast switching speed due to the high electron mobility of GaN and the channel properties of 2DEG.

The GaN material itself is known to have the BV about 10 times higher than that of silicon, and has high thermal conductivity, making it advantageous for heat management. In addition, the GaN has high electron mobility, making it very suitable for high-frequency applications, and has a wide bandgap, so its electrical properties may be maintained stably even at high temperatures.

The GaN HEMT 100 may further include a substrate layer 162. The substrate layer 162 may be formed of a single crystal substrate of silicon carbide (SiC), Si, GaN, or aluminum nitride (AIN). In one embodiment, the substrate layer 162 may be made of silicon (Si).

A buffer layer 152 may be disposed on the substrate layer 162. The buffer layer 152 may be formed of AIN.

An AlGaN layer 142 may be disposed on the buffer layer 152, and the channel layer 132 may be disposed on the AlGaN layer 142.

In addition, the barrier layer 102 may be disposed on the channel layer 132. The channel layer 132 made of GaN and the barrier layer 102 made of AlGaN are layers formed of different bandgap semiconductor devices, so a dense region (or channel) of electrons may be formed at the interface of the two layers..

The D1, the GT, and the D2 may be disposed on the channel layer 132. The GaN HEMT 100 is a horizontal type, and in a vertical direction, the channel layer 132 may be disposed below the D1, the GT, and the D2. In addition, in a horizontal direction, the D1, the GT, and the D2 may be disposed in that order.

A p-GaN layer 112 may be further disposed between the GT and the barrier layer 102 or between the GT and the channel layer 132.

A ground plate 122 may be disposed between the GT and the D2. In the horizontal direction, the ground plate 122 may be disposed between the GT and the D2. Additionally, the ground plate 122 may not be in direct contact with the channel layer 132 and an insulating layer may be disposed therebetween. Additionally, the barrier layer 102 may be disposed between the insulating layer and the channel layer 132.

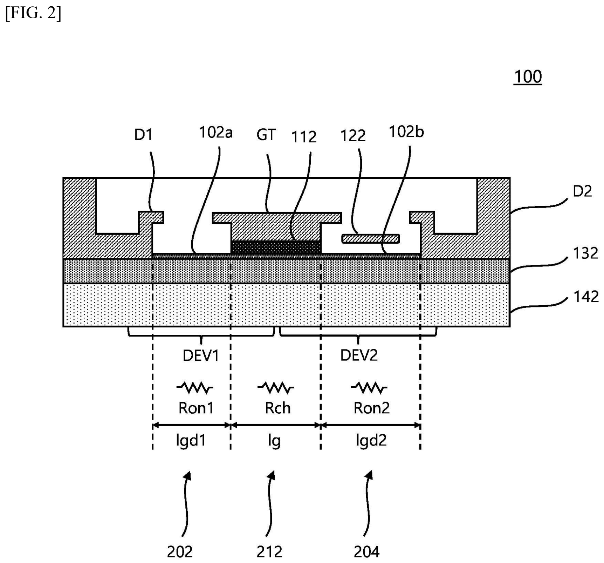

FIG. 2 is an enlarged view of terminals and a channel layer in a cross section of a GaN HEMT according to an embodiment.

Referring to FIG. 2, a first drift region 202, a second drift region 204, and a channel region 212 may be formed in the channel layer 132.

The first drift region 202 may be formed between the D1 and the GT in the channel layer 132. Additionally, the second drift region 204 may be formed between the D2 and the GT in the channel layer 132. Additionally, the channel region 212 may be formed at a location corresponding to the GT in the channel layer 132, for example, at a location below the GT. When the p-GaN layer 112 is disposed below the GT, the p-GaN layer 112 may be disposed on the channel region 212.

When the GaN HEMT 100 is turned on, the resistance Ron to the current flowing from the D1 to the D2 may have a resistance value equal to coupling in series of a first drift resistance Ron1 formed in the first drift region 202, a channel resistance Rch formed in the channel region 212, and a second drift resistance Ron2 formed in the second drift region 204. Ron = Ron1 + Rch + Ron2

The size of the first drift resistance Ron1 may be proportional to a length lgd1 of the first drift region 202. The length lgd1 of the first drift region 202 may be measured as the minimum distance between the edge of the GT and the edge of the D1, which is in contact with the upper surface of the channel layer 132. As the length lgd1 of the first drift region 202 becomes shorter, the size of the first drift resistance Ron1 may become smaller.

The size of the second drift resistance Ron2 may be proportional to the length lgd2 of the second drift region 204. The length lgd2 of the second drift region 204 may be measured as the minimum distance between the edge of the GT and the edge of the D2, which is in contact with the upper surface of the channel layer 132. As the length lgd2 of the second drift region 204 becomes shorter, the size of the second drift resistance Ron2 may become smaller.

Functionally, the GaN HEMT 100 may be configured of two devices DEV1 and DEV2.

The first device DEV1 may be configured of the D1, the GT, and a region corresponding to a location from the D1 to the GT in the channel layer 132.

In addition, the second device DEV2 may be configured of the D2, the GT, and a region corresponding to a location from the D2 to the GT in the channel layer 132.

Additionally, the first device DEV1 may operate as a voltage blocking device, and the second device DEV2 may operate as a high-frequency switching device. The on/off of the GaN HEMT 100 may be determined according to the operation of the second device DEV2, and the BV properties of the GaN HEMT 100 may be determined by the first device DEV1 in a turned-off state.

The ground plate 122 may be disposed in the second device DEV2 between the GT and the D2 to reduce hot carrier injection (HCI).

The barrier layers 102a and 102b may include a first barrier layer 102a and a second barrier layer 102b having different material properties.

The first barrier layer 102a may form a first two-dimensional electron gas region at the interface with the channel layer 132 within the first device DEV1. Additionally, the second barrier layer 102b may form a second two-dimensional electron gas region at the interface with the channel layer 132 within the second device DEV2. In this way, the barrier layers 102a and 102b of different material properties are disposed on each device DEV1 or DEV2, allowing each device DEV1 or DEV2 to exhibit optimal performance. For example, the first device DEV1 may be optimized for performance as a voltage blocking device, and the second device DEV2 may be optimized for performance as a high-frequency switching device.

The on-resistance Ron may have an inverse relationship with the concentration of 2DEG. The higher the concentration of 2DEG, the lower the on-resistance Ron may be. For example, the 2DEG density of the second two-dimensional electron gas region formed in the second device DEV2 may be higher than the 2DEG density of the first two-dimensional electron gas region formed in the first device DEV1. Accordingly, the on-resistance Ron of the second device DEV2 may be further lowered.

When the barrier layers 102a and 102b include an AlGaN material, by varying the Al mole fraction of the AlGaN material in the first device DEV1 and the second device DEV2, the material properties of the first barrier layer 102a and the second barrier layer 102b may be varied, and the 2DEG density may be varied.

By varying the N-type doping concentration of the barrier layers 102a and 102b, the material properties of the first barrier layer 102a and the second barrier layer 102b may be varied, and the 2DEG density may also be varied.

Due to the difference in material properties of the first barrier layer 102a and the second barrier layer 102b, the electron densities of the first two-dimensional electron gas region and the second two-dimensional electron gas region may be different from each other. For example, the electron density of the second two-dimensional electron gas region may be higher than the electron density of the first two-dimensional electron gas region.

The doping concentration of the first barrier layer 102a and the second barrier layer 102b may be different, and the 2DEG density of the first device DEV1 and the second device DEV2 may be different. For example, the 2DEG density of the second device DEV2 may be 1.5 times or more than the 2DEG density of the first device DEV1.

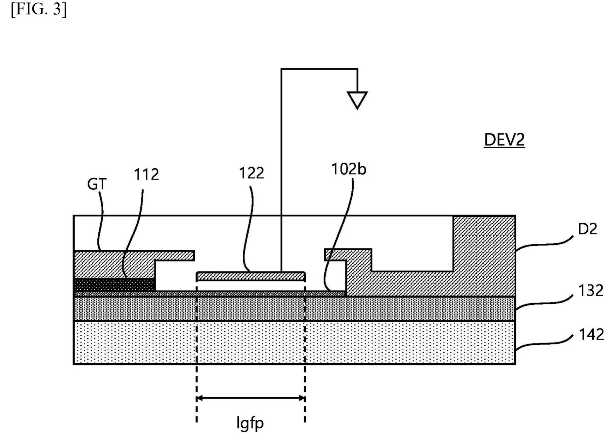

FIG. 3 is a diagram illustrating the configuration of a switching device according to an embodiment.

Referring to FIG. 3, the second device DEV2 (switching device) included in the GaN HEMT may include the D2, the GT, the ground plate 122, the second barrier layer 102b, and the channel layer 132.

On/off of the GaN HEMT may be determined depending on the size of the voltage (hereinafter referred to as gate voltage) formed between the GT and the D2 in the second device DEV2. For example, when the gate voltage is higher than the threshold voltage, the GaN HEMT may be turned on. In addition, when the gate voltage is lower than the threshold voltage, the GaN HEMT may be turned off.

When the gate voltage is higher than the threshold voltage, a channel is formed in the channel region of the GaN HEMT, and electrons may move from the D2 to the D1. In this connection, the electrons may have a very high energy state. This state is also called a 'hot' state. When these high-energy electrons collide with the lattice inside the GaN HEMT, various negative influences may occur. For example, the size of the threshold voltage may change, the device may deteriorate, and a leak current flowing through the insulator of the GT may occur. This negative influence is called the HCI.

The ground plate 122 may alleviate this HCI phenomenon. The ground plate 122 may be connected to the ground. This ground plate 122 may reduce the peak electric field. In addition, the aforementioned HCI phenomenon may be alleviated.

A parasitic capacitance called feedback capacitance may be formed between the GT and the D2. This capacitance may reduce the voltage gain and/or frequency response of the second device DEV2. The ground plate 122 also has the benefit of alleviating this feedback capacitance.

The ground plate 122 also has the benefit of reducing the second drift resistance along with the aforementioned HCI alleviation benefit and feedback capacitance alleviation benefit. However, as the length of the ground plate 122 increases, the length of the second drift region increases, and the size of the second drift resistance may also increase.

In order to reduce the size of the second drift resistance, a designer may determine a length lgft of the ground plate 122 in the direction from the D2 to the GT as the minimum length determined by predetermined design rules DR.

The DR may preset the smallest width or length that may be manufactured in the processes for producing the second device DEV2. According to these DR, the minimum size of lines, gates, holes, etc. may be defined. The length lgft of the ground plate 122 in the direction from the D2 to the GT may be determined as the minimum length of the predetermined DR, through which an increase in the second drift resistance due to the length of the ground plate 122 may be minimized.

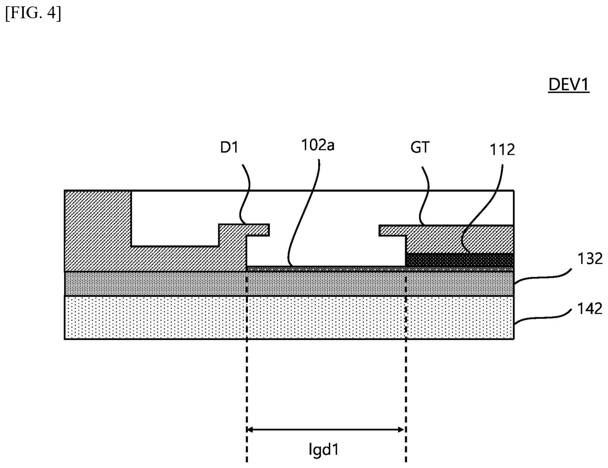

FIG. 4 is a diagram illustrating the configuration of a voltage blocking device according to an embodiment.

Referring to FIG. 4, the first device DEV1 (voltage blocking device) included in the GaN HEMT may include the D1, the GT, the first barrier layer 102a, and the channel layer 132.

Unlike the second device, the first device DEV1 may not include the ground plate. The ground plate may be disposed between the GT and the D2, but may not be disposed between the GT and the D1.

In order to reduce the first drift resistance, the length lgd1 of the first drift region may be designed to be short.

The length lgd1 between the D1 and the GT based on the upper surface of the channel layer 132 may be equal to the minimum allowable length of a predetermined photolithography process. The first drift resistance may be reduced by minimizing the length lgd1 of the first drift region.

However, when the length lgd1 of the first drift region decreases, the size of the BV may decrease. The BV may increase depending on the length of the drift region. As described above, reducing the length lgd1 of the first drift region may have an influence in the direction of lowering the BV.

To compensate for this influence, one embodiment may apply negative biases to the gate voltage.

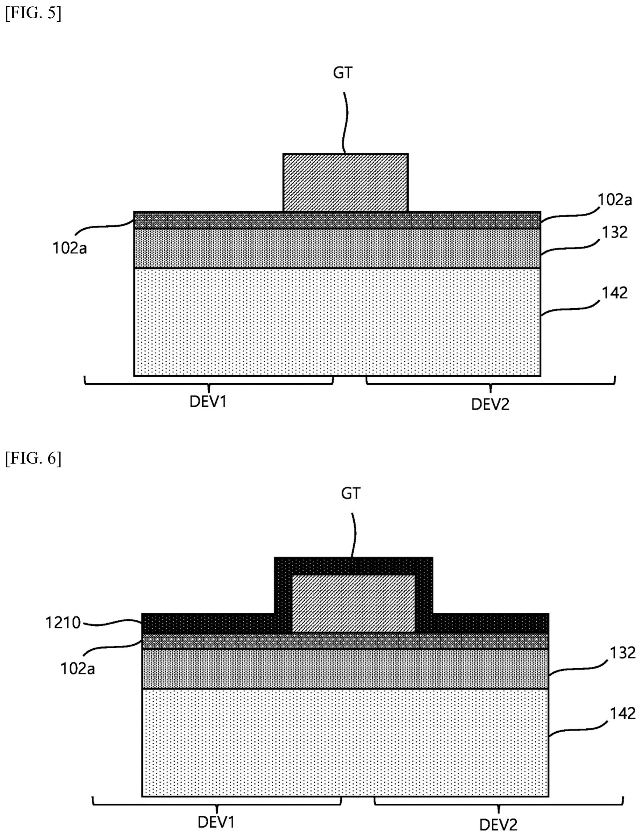

FIGS. 5 to 13 are diagrams illustrating a method of forming barrier layers with different material properties among the manufacturing methods of HEMT according to an embodiment.

Referring to FIG. 5, the channel layer 132 may be formed on the AlGaN layer 142.

In addition, the first barrier layer 102a having first material properties may be formed on the channel layer 132. The first barrier layer 102a may be formed by metal-organic chemical vapor deposition (MOCVD). The MOCVD introduces precursor gases such as metal-organic compounds (for example, trimethyl gallium) and reactive gases (for example, ammonia) into a chamber. When the gas reaches the heated substrate surface, the gas is decomposed by heat and causes a chemical reaction on the surface of the substrate to form the desired thin film. In this connection, metal atoms and other atoms may combine through a chemical reaction to form a thin and uniform film on the substrate. The MOCVD may form high-quality thin films by precisely controlling the thickness and composition at the nanometer level, and may deposit uniform thin films on large-area substrates, making it advantageous for mass production.

In addition, the GT may be formed on the first barrier layer 102a. Although omitted in the drawing, depending on the embodiment, an additional p-GaN layer may be formed below the GT.

After the first barrier layer 102a is deposited, wet cleaning may be performed to remove debris.

Referring to FIG. 6, after the GT is formed, a first protective layer 1210 may be formed on the first barrier layer 102a and the GT. The first protective layer 1210 is a hard mask for protecting the first barrier layer 102a and may be a nitride film. For example, the first protective layer 1210 may be made of silicon nitride (Si3N4) or another nitride.

Then, a photoresist according to photopatterning may be applied on the first protective layer 1210, and development may proceed. Herein, the photoresist may be applied to the region corresponding to the first device DEV1, and may not be applied to the region corresponding to the second device DEV2.

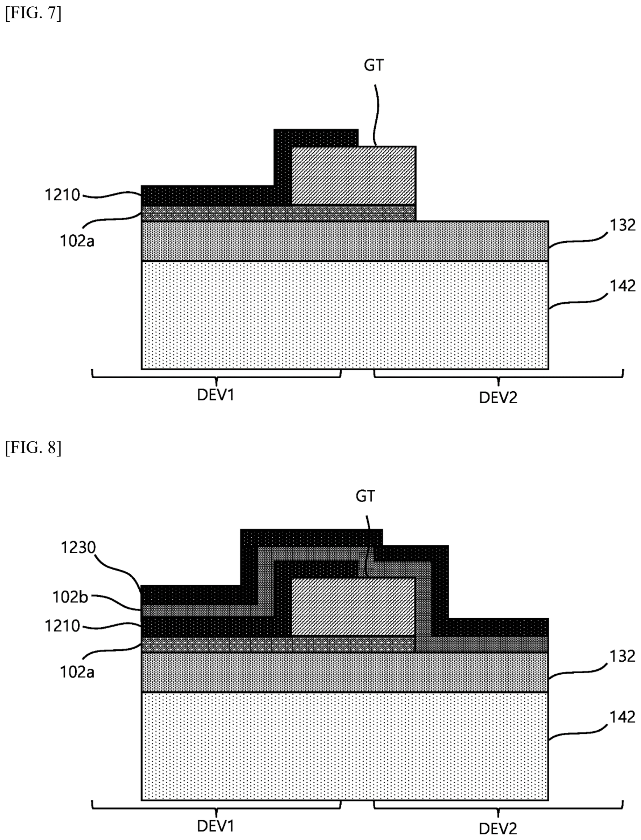

Referring to FIG. 7, after the first protective layer 1210 is formed and the photopatterning is made, etching may be performed using the first barrier layer 102a as an endpoint. Additionally, the photoresist applied in the previous stage may also be removed.

Through this etching, the first protective layer 1210 and the first barrier layer 102a formed on the second device DEV2 may be removed.

After this etching process, wet cleaning may be performed to remove photoresist and etching debris.

Referring to FIG. 8, after the first barrier layer 102a is removed from the second device DEV2, the second barrier layer 102b having different material properties from the first barrier layer 102a may be deposited. The deposition may be the MOCVD.

According to this deposition, the first barrier layer 102a may be formed on the first device DEV1 and the second barrier layer 102b may be formed on the second device DEV2 at the barrier layer level.

Several additional processes may be performed to remove unnecessary portions from the second barrier layer 102b.

First, a second protective layer 1230 may be formed on the second barrier layer 102b. The second protective layer 1230 may be a nitride film like the first protective layer 1210.

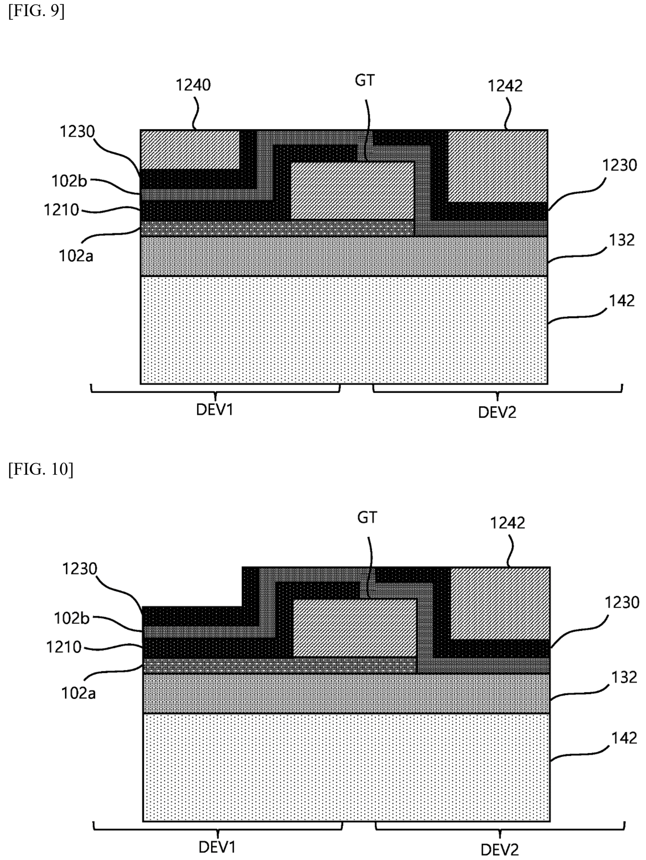

Referring to FIG. 9, oxide films 1240 and 1242 may be formed on the second protective layer 1230. These oxide films 1240 and 1242 may be formed by plasma-enhanced chemical vapor deposition (PECVD). The PECVD may form high-quality thin films at low temperatures. Additionally, the PECVD may also be used on heat-sensitive substrates. To form the oxide films 1240 and 1242 by the PECVD, reactive gases such as silane (SiH4) and oxygen (O2) or nitric oxide (N2O) are introduced into a chamber to generate plasma, and an oxide film may be formed on the second protective layer 1230.

After the oxide films 1240 and 1242 are formed, a polishing process may be performed using the second protective layer 1230 as an endpoint. The polishing process may be a chemical mechanical planarization (CMP) process. The surfaces of the deposited oxide films 1240 and 1242 may be flattened by chemically and mechanically polishing the same.

Through this polishing process, the oxide film may remain separated into a first oxide film 1240 on a first device DEV1 side and a second oxide film 1242 on a second device DEV2 side. Herein, the second oxide film 1242 may serve to protect the second barrier layer 102b of the second device DEV2 in a subsequent additional process.

Referring to FIG. 10, the first oxide film 1240 remaining on the first device DEV1 may be removed while photo-patterning is performed to protect the second barrier layer 102b. The first oxide film 1240 may be removed through, for example, wet etching or dry etching. After removal of the first oxide film 1240, remaining photoresist may also be removed.

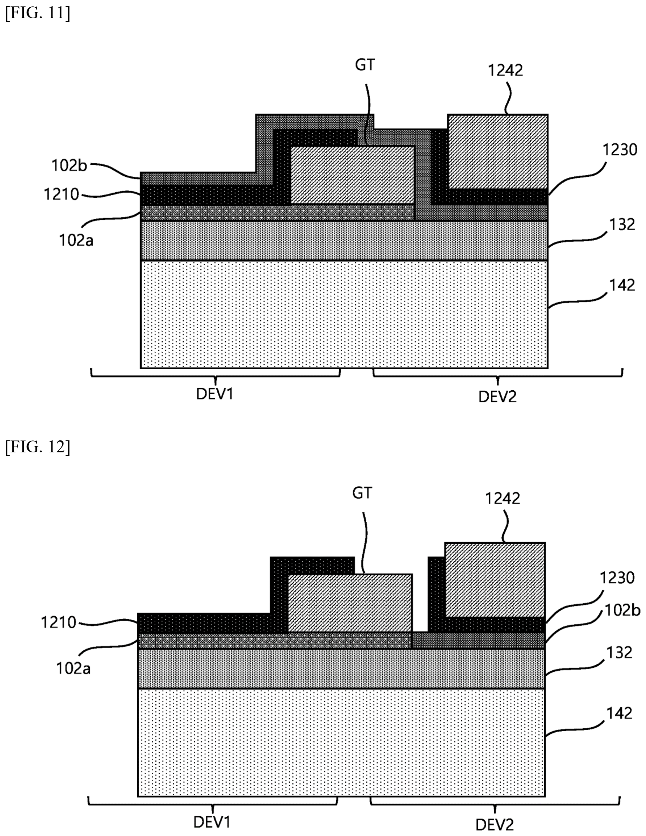

Referring to FIG. 11, after the first oxide film 1240 is removed, the second protective layer 1230 may be removed through an etching process. In this connection, a portion of the second protective layer 1230 may remain due to the influence of the second oxide film 1242.

Referring to FIG. 12, after the second protective layer 1230 is removed, the second barrier layer 102b on the first device DEV1 and the GT may be removed. In this connection, because the second oxide film 1242 functions as a hard mask, the second barrier layer 102b in the second device DEV2 may remain.

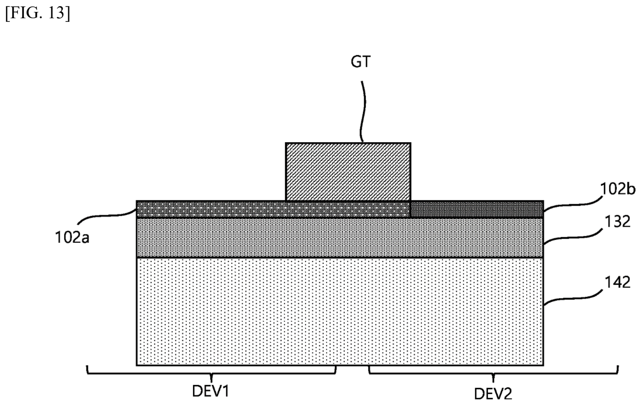

Referring to FIG. 13, the remaining first protective layer, second protective layer, and second oxide film may be removed through a subsequent process such as etching.

Additionally, the first barrier layer 102a and the second barrier layer 102b having different material properties may be formed in the barrier layer.

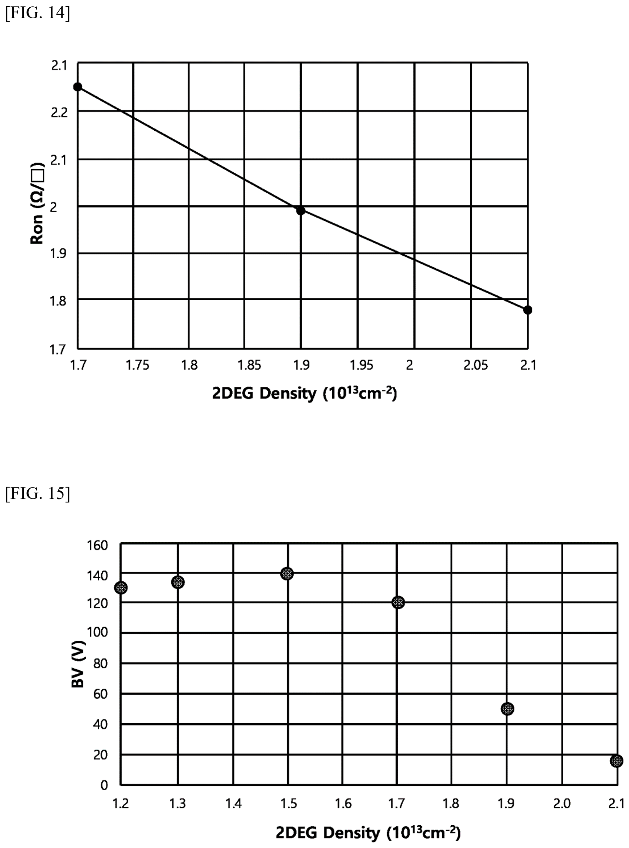

FIG. 14 is a graph showing the relationship between 2DEG density and on-resistance; and FIG. 15 is a graph showing the relationship between 2DEG density and breakdown voltage.

Referring to FIGS. 14 and 15, the on-resistance Ron may have an inverse relationship with the 2DEG density, and the BV and the 2DEG density may have a generally inverse relationship.

In one embodiment, the performance of each device may be optimized and the performance of the entire HEMT may be optimized by varying the 2DEG density in each device for the HEMT configured of a first device and a second device. For example, by forming the 2DEG density of the second device to be higher than the 2DEG density of the first device, for example, by forming the 2DEG density of the second device to be 1.5 times or more than the 2DEG density of the first device, the on-resistance and gate charge of the second device may be made low while maintaining the BV of the first device high.

Through this manufacturing, the apparatus size of the HEMT may be minimized while maintaining high BV and low on-resistance and gate charge.

As described above, an embodiment of the present disclosure may provide the solution for improving on-resistance Ron performance, and provide a technique to enable expansion of bi-GaN application programs and die size reduction for better packing density and lower die cost.

The term "comprises," "includes," or "has" described above should be interpreted not to exclude other elements but to further include such other elements since the corresponding elements may be inherent unless mentioned otherwise. All terms including technical or scientific terms have the same meanings as generally understood by a person having ordinary skill in the art to which the present disclosure pertains unless mentioned otherwise. Generally used terms, such as terms defined in a dictionary, should be interpreted as coinciding with meanings of the related art from the context. It will be understood that terms should not be interpreted in an idealized or overly formal sense unless expressly so defined herein.

Hereinbefore, although the technical ideas of the present disclosure have been disclosed for illustrative purposes, a person having ordinary skill in the art to which the present disclosure pertains will appreciate that various modifications and variations are possible, without departing from the spirit and essential characteristics of the present disclosure. Therefore, the embodiments of the present disclosure are disclosed only for illustrative purposes and should not be construed as limiting the technical ideas of the present disclosure. The scope of protection of the present disclosure should be determined on the basis of the descriptions in the appended claims, and all technical ideas within the scope of equivalents thereof should be construed as being included in the scope of right of the present disclosure

## Claims

1. A high electron mobility transistor (HEMT), comprising:
a first drain terminal;
a gate terminal;
a second drain terminal;
a channel layer, a portion of which forms a first device together with the first drain terminal and the gate terminal, and another portion of which forms a second device together with the second drain terminal and the gate terminal; and
a first barrier layer forming a first two-dimensional electron gas (2DEG) region at an interface with the channel layer within the first device, and a second barrier layer forming a second 2DEG region at the interface with the channel layer within the second device, the first barrier layer and the second barrier layer comprising a barrier layer with different material properties.

2. The HEMT of claim 1, wherein the first device operates as a voltage blocking device, and the second device operates as a switching device.

3. The HEMT of claim 1, wherein the first barrier layer and the second barrier layer comprise an AlGaN material, and Al mole fractions in the first barrier layer and the second barrier layer are different from each other.

4. The HEMT of claim 1, wherein, due to differences in material properties between the first barrier layer and the second barrier layer, electron densities of the first 2DEG region and the second 2DEG region are different from each other.

5. The HEMT of claim 4, wherein an electron density of the second 2DEG region is higher than an electron density of the first 2DEG region.

6. The HEMT of claim 1, wherein a length between the first drain terminal and the gate terminal on an upper surface of the channel layer is different from a length between the second drain terminal and the gate terminal.

7. The HEMT of claim 1, wherein doping concentrations in the first barrier layer and the second barrier layer are different from each other.

8. The HEMT of claim 1, wherein:
the HEMT is a horizontal type; and
the channel layer is disposed below the first drain terminal, the gate terminal, and the second drain terminal in a vertical direction; the first drain terminal, the gate terminal, and the second drain terminal are disposed in that order in a horizontal direction; and a ground plate is disposed between the gate terminal and the second drain terminal in the horizontal direction.

9. The HEMT of claim 8, wherein the ground plate is disposed between the gate terminal and the second drain terminal and is not disposed between the gate terminal and the first drain terminal.

10. A high electron mobility transistor (HEMT), comprising:
a first drain terminal;
a gate terminal;
a second drain terminal;
a channel layer, a portion of which forms a first device together with the first drain terminal and the gate terminal, and another portion of which forms a second device together with the second drain terminal and the gate terminal; and
a barrier layer that forms a two-dimensional electron gas (2DEG) region at an interface with the channel layer and forms the 2DEG regions of different densities in the first device and the second device.

11. The HEMT of claim 10, wherein a material property of the barrier layer in the first device and a material property of the barrier layer in the second device are different from each other.

12. The HEMT of claim 11, wherein the barrier layer comprises an AlGaN material, and an Al mole fraction of the AlGaN material in the first device and the second device is different from each other.

13. The HEMT of claim 11, wherein an N-type doping concentration of the barrier layer in the first device and the second device is different from each other.

14. The HEMT of claim 10, wherein a 2DEG density of the second device is 1.5 times or more than a 2DEG density of the first device.

15. The HEMT of claim 14, wherein the first device operates as a voltage blocking device, and the second device operates as a switching device.

16. A method of manufacturing a high electron mobility transistor (HEMT), the method comprising:
forming a channel layer in the HEMT, a portion of which forms a first device together with a first drain terminal and a gate terminal, and another portion of which forms a second device together with a second drain terminal and the gate terminal;
forming a first barrier layer having a first material property on the channel layer;
forming the gate terminal on the first barrier layer;
forming a first protective layer on the first barrier layer and the gate terminal;
removing the first protective layer and the first barrier layer from the second device through etching; and
forming a barrier layer comprising the first barrier layer and a second barrier layer with different material properties by laminating the second barrier layer having a second material property on the etched portion of the first barrier layer.

17. The method of claim 16, further comprising:
laminating the second barrier layer having the second material property on the etched portion of the first barrier layer and then forming a second protective layer on the second barrier layer;
forming an oxide film on the second protective layer;
polishing the oxide film using the second protective layer as an endpoint;
removing a first oxide film remaining in the first device among the oxide films;
removing the second barrier layer and the second protective layer from regions of the oxide films excluding the portion protected by a second oxide film remaining in the second device; and
removing the remaining second oxide film and the first protective layer.

18. The method of claim 16, wherein the first barrier layer and the second barrier layer are formed by metal-organic chemical vapor deposition (MOCVD).

19. The method of claim 17, wherein the oxide film is formed by plasma-enhanced chemical vapor deposition (PECVD).

20. The method of claim 17, wherein the polishing is chemical mechanical planarization (CMP).
